# EUROPEAN PATENT SPECIFICATION

(11) **EP 0 240 667 B1**
(45) Date of publication and mention of the grant of the patent: **21.07.1993**
(21) Application number: 87101841.2
(22) Date of filing: 10.02.1987
(51) Int. Cl.: G06F 15/16

(54) **Processor**
Prozessor
Processeur

(30) Priority: 12.03.1986 JP 52448/86; 20.10.1986 JP 247436/86
(43) Date of publication of application: 14.10.1987
(73) Proprietor: HITACHI, LTD., Chiyoda-ku, Tokyo 101 (JP)
(72) Inventor: Kametani, Masatsugu, Niihari-gun Ibaraki-ken (JP)
(74) Representative: Beetz & Partner Patentanwälte

(56) References cited:
- EP-A- 0 123 509
- GB-A- 2 134 676
- US-A- 4 204 251
- US-A- 4 214 305
- US-A- 4 237 534
- NACHRICHTENTECHNIK ELEKTRONIK, vol. 29, no. 7, 1979, pages 271-276, VEB, Berlin, DE; A. TSCHELEBIEV: "Speicherkopplung ungleicher Mikroprozessoren"
- ELECTRONICS DESIGN, vol. 32, no. 15, 26th July 1984, pages 155-166, Waseca, MN, DENVILLE, NJ, US; P. MADAN et al.: "Bit-oriented coprocessor resolves incompatibilities of small and large networks"

## Description

### BACKGROUND OF THE INVENTION

This invention relates to a processor suitable for constructing a single processor system or multiprocessor system.

A conventional multiprocessor system, as shown for example in U.S. Patent No. 4,494,188, consists primarily of a CPU, a memory, and a common bus switch which operates on a master-slave basis with other processor elements. Such a multiprocessor system configured by single-CPU processor elements operates favorably so far as a customized task process under less disturbances is concerned. However, as the process charged on the system becomes more sophisticated, such as the case of the intellectualized control process, overhead system supports including the management of the data base and system status, the organization of the intelligent processing system based on the data base or sensor information, multi-interrupt processing, and multijob functions are rendered indispensable, and in general these processes are programmed by a high grade language and executed under a high grade operating system with the realtime multitasking and multijob supporting abilities.

In the above-mentioned conventional multiprocessor system, the realtime control process which is the main object of speedup is treated as one of tasks carried out by multitasking, and therefore at present the system cannot implement a tight-linked parallel processing due to the task switching overhead and disordered parallel processing schedule.

On this account, the intelligent processing system is often separated from the parallel-processed control processing system by employment of a super minicomputer as a supervisory system, but in this case, there are several problems as follows:
(1) the communication between the control processing system and intelligent processing system is apt to become less frequent, therefore, the advantages of distributed intelligent processing and system management which generally necessitate operating system overhead for controlling the internal status of each own processor are not effectively exerted, resulting in a degraded cost-effectiveness evaluation, and
(2) it is difficult to expand the processing ability of the intelligent processing system to match the expansion of the processing ability of the control processing system and also difficult to improve the communication throughput between the two systems. Accordingly, when specifically the control loop of the control processing system is sped up, a relatively large amount of data needs to be transacted between the intelligent processing system and control processing system, but this is impeded by the hardware restriction due to the above-mentioned problems, resulting in a significant deterioration in the cost-effectiveness evaluation.

In US-A-4 214 305 is disclosed a multiprocessor data processing system which comprises in addition to a main memory unit which is common to a plurality of processors, a queue buffer which is common to the processors to store intercommunicating information for the processors, whereby, when each processor completes a process, information relating to the process is stored in the main memory unit and the first address of this information or the intercommunicating information is transmitted to the queue buffer from which any idle or vacant processor reads out the intercommunicating information.

Nachrichtentechnik Elektronik, Vol. 29, No. 7, 1979, pages 271-276, VEB, Berlin, DE; A. Tschelebiev: "Speicherkopplung ungleicher Mikroprozessoren" treats multiprocessor structures and suggests the use of dual-port-RAMs.

### SUMMARY OF THE INVENTION

An object of this invention is to provide a processor system capable of improving, at well balance and efficient qualities, the processing ability of a multiprocessor system which is suitable for versatile processing.

This object is achieved by the invention by the features of claim 1.

The processor system according to the invention provides a hardware architecture which allows the two CPUs in the base processor element to operate as if they are a single processor. With attention being paid to the high independency of the control processing system and intelligent processing system based on the data base and sensor information, the control processing system is alloted to the main processing system with the main CPU so that control arithmetics are implemented by the tight-linked parallel processing in unison with other base processor elements, while the intelligent processing system for dealing with overhead processings including the interrupt process, system mangement and intelligent process is alloted to the background processing system of the main CPU and to the background CPU so as to backup the control processing system of the main CPU. In consequence, the task switching overhead and interrupt events which disturb the parallel processing for control processing system are eliminated as much as possible and the highly independent two processing systems are operated in parallel efficiently, whereby the processing ability of the base processor element is virtually doubled by addition of the processing ability of two CPUs, and also in a multiprocessor system where several base processor elements are linked the total processing ability is doubled as compared with the conventional system and the processing ability can be expanded, at well balanced grades between the control processing system and intelligent processing system, as the number of base processor elements is increased.

Other objects and features of this invention will be more apparent from the following description of certain preferred embodiments of the invention.

### BRIEF DESCRIPTION OF THE DRAWINGS

Fig. 1 is a block diagram showing the internal arrangement of the base processor element according to this invention and part of the multiprocessor system configured by the base processor element;
Fig. 2 is a diagram showing the switching sequence for the common bus (BPE local bus) shared by the two CPUs in the base processor element according to this invention;
Fig. 3 is a diagram showing the sequence of processes carried out interactively between the two CPUs in the base processor element;
Fig. 4 is a basic logic diagram of the common bus switch according to this invention;
Fig. 5 is a block diagram of the dual-port RAM according to this invention;
Fig. 6 is a block diagram showing another embodiment of this invention applied to an intelligent automatic machine; and

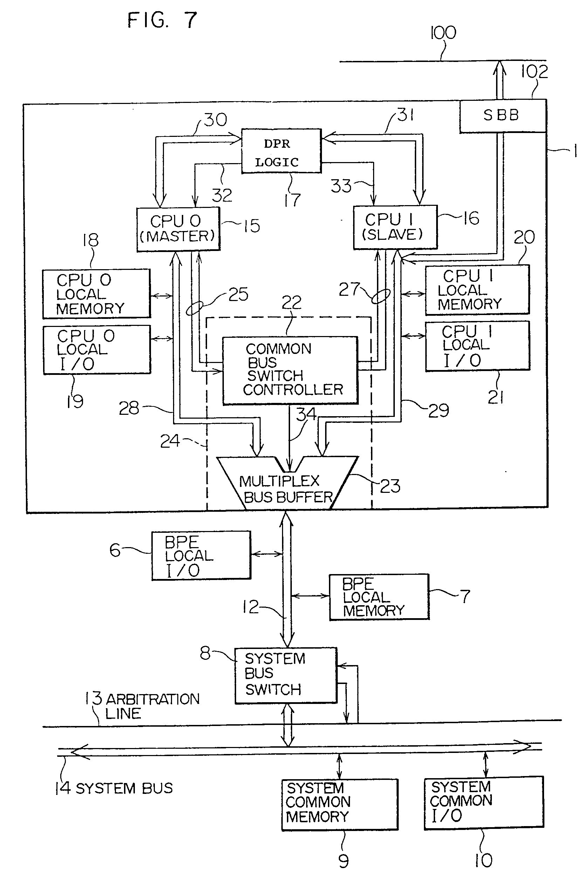

Fig. 7 is a block diagram showing the processor in the system of Fig. 6.

### DESCRIPTION OF THE PREFERRED EMBODIMENTS

The invention will now be described in detail with reference to the drawings.

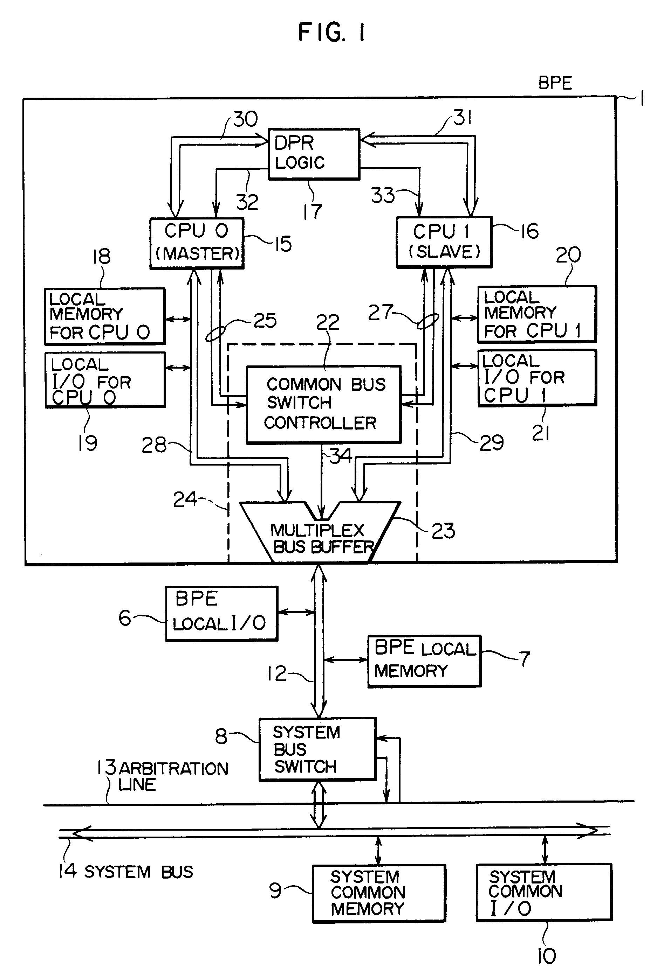

In Fig. 1 showing the arrangement of the inventive processor, a base processor element (BPE) 1 for organizing a multiprocessor system includes two CPUs 15 and 16 (CPU0 and CPU1), a dual-port RAM (DPR) 17 as a communication facility between the CPUs 15 and 16, and a common bus switch 24 including a multiplex bus buffer 23 which is controlled consistently by a common bus switch control circuit 22 for connecting any of the CPUs to a BPE local bus 12 shared by the CPUs for establishing communication with other base processor elements (BPEs). The CPUs 15 and 16 have associated with local memories 18 and 20 and local input/output (I/O) units 19 and 21, respectively, so that they can usually operate independently. The dual-port RAM (DPR) 17 which supports the communication between the CPUs features to have communication interrupt lines 32 and 33 to the CPUs 15 and 16, allowing inter-CPU communication with little overhead. The local bus 12 of the base processor element 1 is in connection with a local memory 7 and local I/O unit 6 associated with the base processor element, and at the same time the bus 12 constitutes a common bus line for connection with other base processor elements. Further provided on the local bus 12 is a system bus switch 8 which connects the base processor element to a system bus 14 on which a common system memory 9 and common system I/O unit 10 are connected. The system bus switch 8 implements the bus arbitration process for system bus requests by using an arbitration line 13 so that the common resources on the system bus 14 are used properly and parallel processings are carried out among the base processor elements through the communication process with other base processor elements.

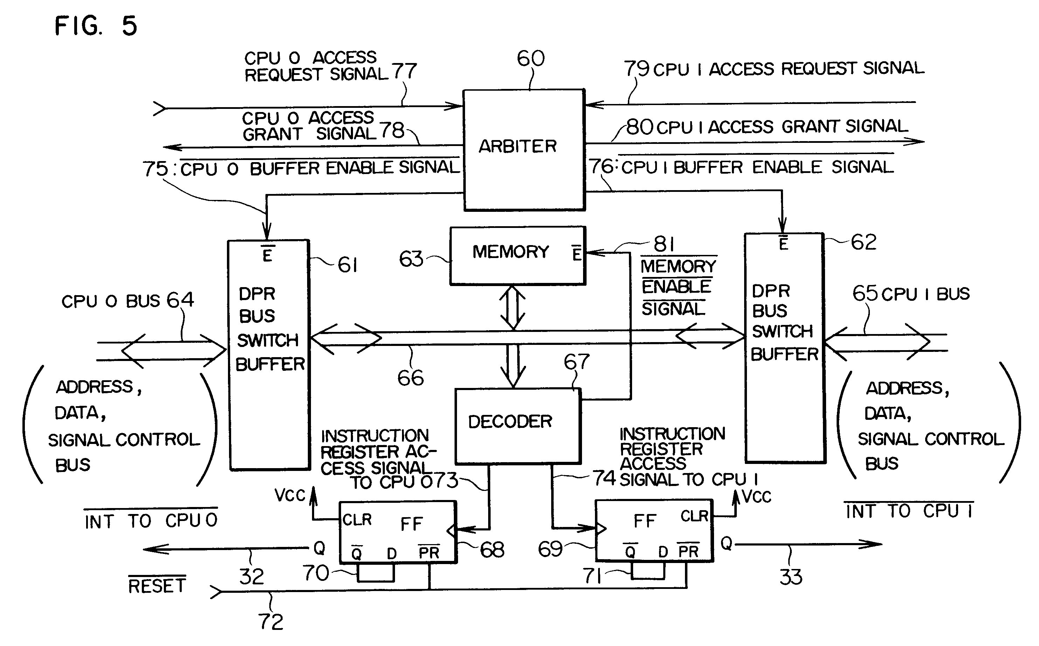

Fig. 5 shows in block diagram the dual-port RAM (DPR) 17, which can be regarded as a memory shared by the CPUs 15 and 16. The DPR 17 includes an arbiter 60 which implements arbitration for the CPUs 15 and 16 in making access to the dual-port RAM (DPR) by using access request signals and access grant signals symbolized as 77 through 80 for each processor, bus switches 61 and 62 which selectively connect the CPU bus 64 or 65 to the internal bus 66 in accordance with the enable signal 75 or 76 issued by the arbiter 60, a decoder 67 which decodes the address and control signals on the internal bus 66 to produce the memory enable signal 81 and interrupt control signals 73 and 74, and flip-flops 68 and 69 which set or reset the interrupt signals 32 and 33 in response to the interrupt control signals 73 and 74 produced by the decoder 67. The dual-port RAM (DPR) has a unique interrupt function for inter-CPU communication, which establishes a register for generating an interrupt to CPU0 and a register for generating an interrupt to CPU1 at certain addresses of the DPR, and at the same time defines these registers to be instruction registers directed to the partner CPUs, thereby implementing instruction reception and interrupt generation at the same time. In an example of instruction issuance by CPU1 to CPU0, the CPU1 initially sets the attribute of the instruction to be executed by CPU0 in its own register and then stores it in the instruction register (interrupt generation register) directed to CPU0 in the DPR, then the decoder 67 knows, by monitoring and decoding the internal bus 66 of the DPR, that the instruction register directed to CPU0 is accessed, and sends the instruction register access signal to CPU0 by using the access signal 73 so that the value of the Q̅ signal 70 is latched in the flip-flop 68. Since the flip-flop 68 has been initialized to Q=high and Q̅=low by the reset signal 72, the above operation causes the flip-flop to produce Q=low and Q̅=high, and the low-active interrupt signal 30 to CPU0 is activated.

Accepting the interrupt, CPU0 again makes reference to the instruction register directed to it in order to fetch an instruction to be executed in its own interrupt service routine, and when it reads out an indicated instruction, the decoder 67 which constantly monitors the access situation provides an instruction register access signal for CPU0 to the flip-flop 68 by using the access signal 73 so as to latch a high Q̅ output 70 and output a high to Q. Namely, the interrupt generation line 32 to CPU0 is deactivated. By the foregoing sequence, a series of operations from interrupt generation to interrupt acceptance and operations related to instruction reception on a software basis are carried out concurrently and at a minimal overhead.

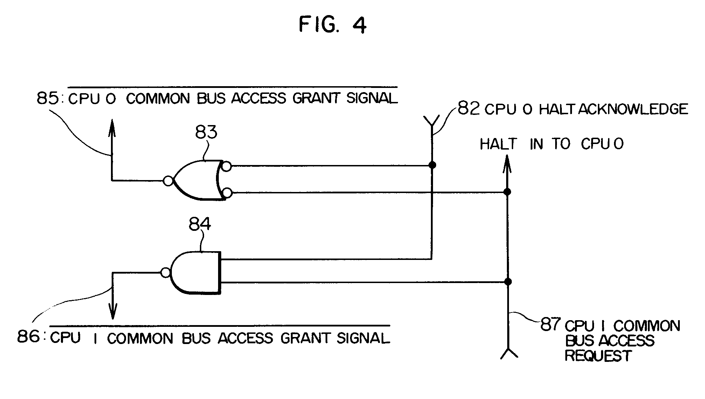

Returning to Fig. 1, the common bus switch 24, which selects one of the buses 28 and 29 of CPU0 and CPU1 in the base processor element (BPE) 1 and implements bus switching control for the output to the BPE local bus 12 regarded as a shared bus for CPU0 and CPU1, consists of the aforementioned common bus switching control circuit 22 and the multiplex bus buffer 23 controlled by the circuit 22. The bus switching control, for the case of a master CPU0 and slave CPU1, is implemented by a common bus switching logic made up of a NOR gate 83 and a NAND gate 84 as shown in Fig. 4.

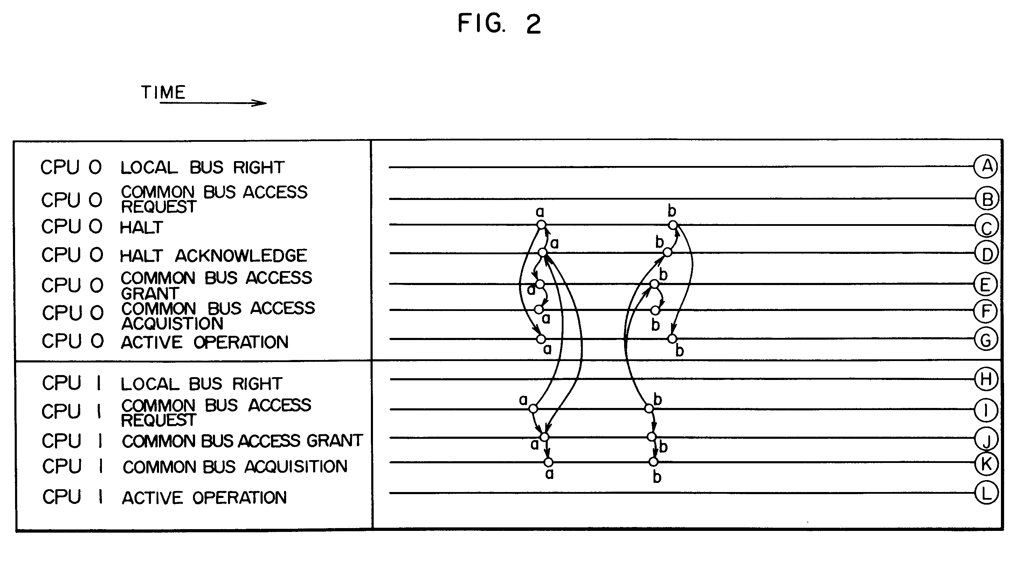

The following describes the unique bus switching control sequence in connection with the timing chart of Fig. 2. Initially, the access right for the two CPU local buses 28 and 29 always resides on the CPU side and it is never infringed by other devices on the bus Ⓐ, Ⓗ. The common bus (BPE local bus 12) access request by CPU0 is always active as shown by Ⓑ, while that of CPU1 is made active when necessary as shown by Ⓘ. Namely, CPU0 normally takes the bus, except only when CPU1 is using it. In the example shown in Fig. 2, the CPU1 raises a common bus access request 87 at Ⓘa, and CPU0 responds to the request to terminate the instruction process at that time point and output a halt acknowledge 82 immediately when it becomes possible to release the bus right at Ⓓa and then deactivates the CPU0's common bus access grant signal 85 (driven by the gate 83) at Ⓔa and releases the bus as shown by Ⓕa. At Ⓒa, CPU0 enters the halt state and at the same time at Ⓙa the CPU1's common bus access grant signal 86 (driven by the gate 84) is activated, causing the bus switch buffer 23 to be selected on the CPU1 side as shown by Ⓚa, and the bus right is passed to CPU1. When the time comes when CPU1 can release the common bus following the use, it deactivates the CPU1's common bus access request 87 as shown by Ⓘb. This is immediately followed by the active transition of the CPU0's common bus access grant signal 85 at Ⓔb, causing the bus switch buffer 23 to be selected on the CPU0 side, and after the bus right is passed to CPU0 its halt acknowledge is reset at Ⓓb and CPU0 makes a transition from the halt state to the active state at Ⓒb. In the timing chart, symbols Ⓖ and Ⓛ indicate the active states of CPU0 and CPU1, respectively. In the foregoing master (CPU0) and slave (CPU1) operation, CPU0 is in the halt state for a duration between Ⓕa and Ⓕb when the bus right is held by CPU1 and a little while between Ⓕb and Ⓑb for the bus switch timing adjustment. Accordingly, CPU1 rather than CPU0 behaves a master's operation from the viewpoint of activity right. A mode is provided to pass the bus right to CPU0 at each data transfer so that CPU0 is not precluded from operating due to a too long halt time. However, as will be described later, for a multiprocessor system using CPU1 as a background CPU for implementing intellignet processings for supporting the main CPU0, adoption of a distributed intelligent base configuration of the functional structure in units of base processor element (BPE) allows each processor to receive most of necessary data in its neighborhood and to have most of data communication through the dual-port RAM (DPR). On this account, transaction of intelligent information among base processor elements (BPEs) is less frequent than information transaction by CPU0 with other base processor element (BPE) for the purpose of tight-linked parallel processing, and therefore loss of processing ability of CPU0 according to this invention is conceivably small. In another case where CPU1 has a fixed role to back up CPU0 and performs system management, it is more efficient for the system to have the CPU0's operation control right committed to CPU1, and the inventive common bus control is said to be suited for the local distributed processing as described above.

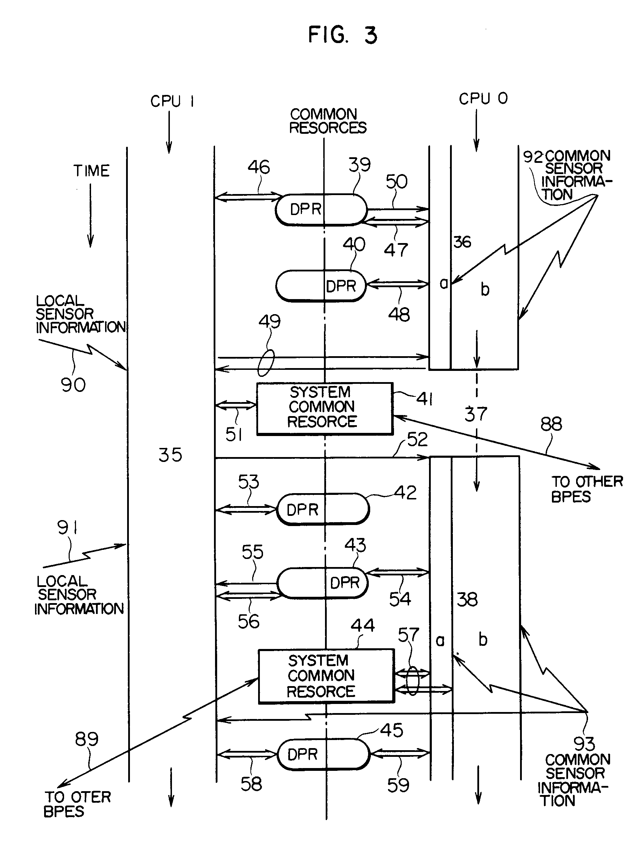

The general operation of the foregoing inventive processor will be described in detail with reference to Fig. 3.

Fig. 3 is based on the assumption that CPU0 performs primary control arithmetics, while CPU1 backs up the CPU0 by implementing intelligent processings based on the intelligent base (distributed) and sensor information and also implementing the system management, so that the system operates for local distributed processings. In the case of a multiprocessor configuration, each base processor element (BPE) is assumed to perform a tight-linked parallel processing primarily and a rough-linked parallel processing on a background basis. Reference number 35 shows the sequence of process by CPU1, and 36, 37 and 38 show the sequence of processes by CPU0. Common resources include a dual-port RAM (DPR) which is a local memory shared by CPU0 and CPU1 in the base processor element (BPE), and system common resources on the system bus 14 accessible from all base processor elements (BPEs) in the case of a multiprocessor configuration. Symbols 47, 48, 54 and 59 indicate communications between CPU0 and DPR, while symbols 46, 53, 56 and 58 indicate communications between CPU1 and DPR. Similarly, symbols indicate communications between CPU0 and system common resources and between CPU1 and system common resources, respectively, and these are regarded as accesses from base processor elements (BPEs) when observed from the system common resources. Symbol 50 indicates an interrupt to CPU0 by utilization of the interrupt function of the dual-port RAM (DPR), and symbol 55 indicates a similar interrupt to CPU1. Symbol 49 indicates a common bus access request signal issued by CPU1 to CPU0 and a corresponding bus access grant signal issued by CPU0 in the handshaking operation, and symbol 52 shows the transition of bus right which has once been acquired by CPU1 and is now released and returned to CPU0. Symbols 88 and 89 indicate accesses from other BPEs to the system common resources. Symbols 90 and 91 show receptions of external sensor information as part of intelligent of information during the process of CPU1, and similarly symbols 92 and 93 show reception by CPU0 and CPU1 of sensor information shared with other BPEs. Concerning the processings performed by CPU0 and CPU1, the CPU0 operates as a main processing system to control, in unison with CPU0s of other base processor elements (BPEs), part of an intelligent machine system, e.g., the arm of a human-type intelligent robot, by executing tight-linked parallel processes 36b and 38b among the CPU0s so that numerous control arithmetic tasks are treated at as high parallelism as possible, and it implements as a background intelligent processing system in unison with CPU1 having the process 35 the intelligent processing and system management shown by 36a and 38a in the idle time after a process has been passed to an auxiliary processor, e.g., arithmetic processor, the idle time which occurs during the synchronous process with other base processor element (BPE), and at a process request by interrupt from other base processor element (BPE), CPU1, or system common resources. The intelligent processing system carried out by the base process element (BPE) possesses as a data base information for a further smaller part of the robot arm portion, e.g., information related to muscles, receives related local sensor information as sense information, and executes the intelligent processing related to the muscular portion on the basis of the local function-distributed data base organized as above, thereby backing up the whole control arithmetics carried out by the main processing system.

For the foregoing assumed system, the sequence of processes by CPU0 and CPU1 shown in Fig. 3 will be traced briefly. Initially, CPU0 and CPU1 are on the way of their processes 36 and 35 shown in Fig. 3. CPU1 abruptly develops the need of communication with CPU0, and carries out the operation 46 at time point 39 for writing a communication message in the dual-port RAM (DPR) and writing a command for the message in the instruction register directed to CPU0. This operation generates an interrupt 50 to CPU0, causing the background processing system of CPU0 to access the dual-port RAM (DPR), and communication 47 for necessary information takes place. At time point 40, CPU0 meaninglessly writes and reads data shared with the partner CPU without handshaking to and from the dual-port RAM (DPR). Various sensor information is also processed sequentially or referenced by programs by being entered as interrupts raised by the sensors. Next, CPU1 develops the need of communication with a system common resource for the purpose of communication with other BPE, acquires the bus right for the common bus (BPE local bus) 12 at time point 49, has a communication 51 with the system common resource at time point 41, and after communication returns the bus right back to CPU0 at 52. During the above communication, CPU0 is held in a halt state 37 and, after the halt state has been lifted at 52, it proceeds to a process 38 continuative from the process 36. At the following time point 42, CPU1 has a meaningless communication of data shared among the CPUs with the dual-port RAM (DPR), and at 43 CPU0 has an instruction-attached handshake data communication with CPU1 in the same way as 39. At time point 44, CPU0 has a communication 57 with a system common resource, and in this case the communication includes one related to intelligent processing during the background process 38a and one for tight-linked parallel processing data related to control arithmetics during the main processing 38b, and these communications do not affect at all the process and operation of CPU1. Although symbol 45 indicates concurrent meaningless communications of CPU0 and CPU1 with the dual port RAM (DPR), the arbiter 60 performs proper arbitration control so that the communications take place without any inconvenience to their processes and operations.

When the foregoing intelligent processing system formed of local distributed data bases and control processing system backed up by it is realized by application of the inventive processor, most of the intelligent processes can be executed among the CPUs within the base processor element (BPE) through the dual-port RAM (DPR), with occasional accesses being made to the system common resources for transacting their process results and the intelligent process results provided by other base processor elements (BPEs), whereby the best communication throughput can be accomplished in a natural manner among the communication nodes within the system, and the consequent parallel operations in virtually complete independence between the control processing system and intelligent processing system can surely double the processing ability. Furthermore, by the additional installation of BPEs, the processing ability of the intelligent processing system and control processing system is enhanced proportionally at always well balanced grades between the systems.

According to this embodiment of the present invention, a processor element (base processor element: BPE) which is the fundamental component in constructing a multiprocessor system or single processor system is formed using two CPUs, which seem a single CPU when observed from outside, linked through a dual-port RAM (DPR) with the interrupt function and a common bus shared by the CPUs. The two CPUs are alloted to a high-independence main processing system and background processing system separately, with local information exchange between the CPUs being made through the dual-port RAM (DPR) and communication with other base processor elements (BPEs), in the case of a multiprocessor configuration, being made by way of system common resources on the system bus through a common bus (BPE local bus), whereby the BPE ability is virtually doubled.

When a multiprocessor system is constructed using the inventive processor, where the data base for the background processing system is distributed to each BPE, the background processing system has most of communication within each processor and does not necessitate frequent communication with other processors, and the consequent optimization of communication throughput among the communication nodes enables natural and high-efficiency parallel processings for both of the main processing system and background processing system wihtout a significant influence of local communications on the tight-linked parallel process carried out by the main system. By additional installation of the inventive processor, the processing ability can be enhanced at always well balanced grades between the main and background processing systems.

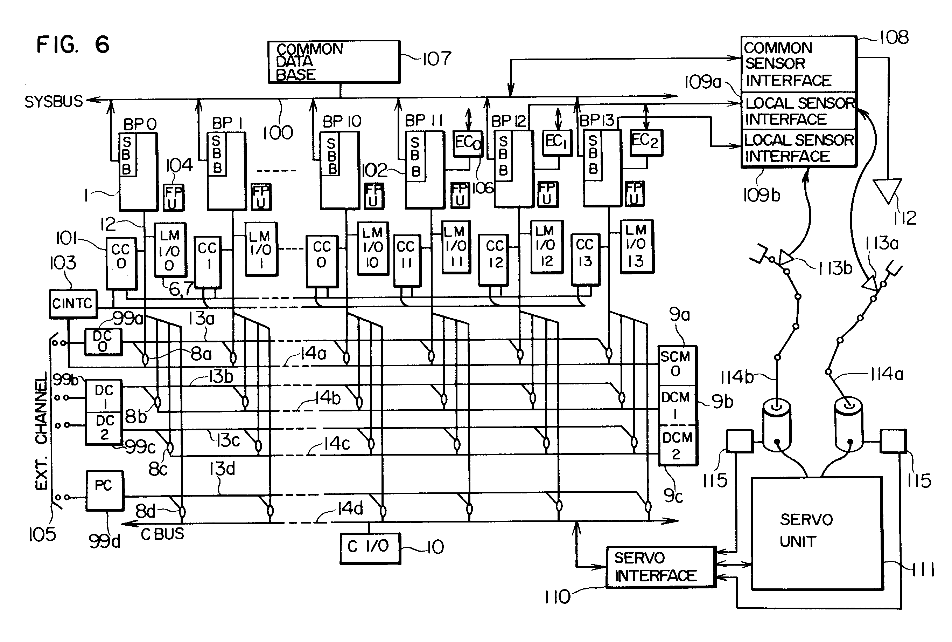

Next, the expansion of the inventive base processor element (BPE) to a multiprocessor system and an example of the intelligent robot system arranged by use of the multiprocessor system will be described with reference to Fig. 6.

In Fig. 6, reference number 1 denotes base processor elements (BPEs) of this invention. Each base processor element 1 is connected to common buses 14a-14d by a BPE local bus 12. Symbols 99a-99d denote bus arbiters for the respective common buses 14a-14d, and symbols 13a-13d are associated arbitration lines. The common buses 14a-14c are private buses for shared memory systems 9a-9c, respectively, while the bus 14d is a bus for a common I/O unit. The four common buses have individual access rights normally taken by CPU0 (shown by 15 in Fig. 1) which is alloted to the control processing system in the BPE 1, and they are also used by CPU1 (shown by 16 in Fig. 1) which is alloted to the intelligent processing system when necessary. Accordingly, the common buses 14a-14d are roughly considered to be private buses for the control processing system.

CPU0 in each base processor element uses the common buses for communication and carries out necessary control arithmetics as tight-linked parallel processes.

Reference number 101 denotes a hardware unit (communication controller) for controlling parallel processings, and 103 denotes a hardware unit (communication interrupt controller) for controlling interrupt-based communications among base processor elements. The base processor element is provided with a bus switch circuit 102 which supports the system bus 100 as a common bus dedicated to the intelligent processing system and a local bus for CPU1 which is alloted to the intelligent processing system. Placed on the system bus 100 are a common data base 107 and various shared sensors and interfaces. The local bus for CPU1 which is alloted to the control processing system is provided with a floating point arithmetic unit (FPU) 104 used for high-speed arithmetic operations.

The multiprocessor system of this embodiment comprises a total of 14 base processor elements, and the system in modules is provided with an external expansion channel 105 of the type of direct hardware communication unit linkage and an external expansion channel 106 of a software intervention type so that many modules can be linked together. The use of the external expansion channel 105 (hardware direct linkage type) allows high-speed reference to the internal common memories 9a-9c directly from an external module, while the use of the external expansion channel 106 (software intervention type) allows high-grade, flexible communications based on a certain protocol with other modules.

Using the base processor element arranged as described above, a multiprocessor system which effectively supports the control processing system and intelligent processing system, as described above, can be organized.

The multiprocessor system shown in Fig. 6 is linked with a robot system, as a control object, and it will be described in the following.

The robot system includes robot mechanisms 114a and 114b, a servo unit (including power amplifiers) 111, sensors 113a and 113b equipped on the robot mechanisms 114a and 114b, and another sensor, e.g., television camera, 112. The multiprocessor system of this embodiment performs high-speed coordinate transforming process and dynamical arithmetic process on the part of the control processing system, and delivers the resulting position, speed and acceleration commands to the servo unit 111 by way of a servo interface 110 on the common I/O bus. Conversely, the current operational state of the robot is detected using sensors 115 including encoders, tachogenerators, acceleration sensors and motor current sensors, and the servo unit 111 sends the results of detection as feedback data to the multiprocessor system by way of the servo interface 110. The control processing system in the multiprocessor system uses the feedback data and commands and data provided by the intellignet processing system to calculate subsequent command values to be fed to the servo unit 111. The sensor 112 shared by the two robot mechanisms 114a and 114b sends data to the system bus 100 through a common sensor interface 108, while the sensors 113a and 113b provided individually on the robot mechanisms 114a and 114b send data directly to the intelligent processing systems of individually functioning base processor elements by way of local sensor interfaces 109a and 109b. Based on the information from the sensors 112, 113a and 113b and a common data base 107, the intelligent processing system performs intelligent processings including learning and inferring and provides the results to the control processing system.

According to the above embodiment of this invention, the control processing system performs high-grade dynamical control arithmetics under the support of the high-grade intelligent process, and consequently an intelligent automatic machine control system, such as an intelligent robot, with sensing, inferring and learning functions and abilities of high-speed and high-accuracy motions can be constructed.

According to the above embodiment of this invention, a base processor element, which constitutes the controller for an intelligent automatic machine control system such as an intelligent robot, can implement a control processing system and an intelligent processing system separately, whereby the processing abilities and functions of both systems can be expanded at well balanced grades in the single processor environment or multiprocessor environment. By providing in the base processor element a dual-port RAM dedicated to the local tight-linked communication between the intelligent processing system and control processing system and connecting the two systems directly to the associated CPUs, the possibility of communication disturbance in the control processing system and serious bus contention in the multiprocessor environment can be reduced significantly, whereby communication throughput between the systems and among functions can be made optimal.

By providing a bus switch interface (multiplexer bus buffer and common bus switch control circuit) of a master-slave type for supporting the common bus accessible from the two CPUs in the base processor element so that the base processor in dual-CPU formation is reformed to a single processor, base processors can easily be linked with a plurality of buses, whereby the processing ability and function can be expanded efficiently and uniformly.

According to this invention, as described above, the processing ability of the multiprocessor system or single processor system suitable for general-purpose processings can be enhanced efficiently at well balanced grades.

Moreover, according to this invention, the control processing system, which performs high-grade and high-load dynamical control arithmetic processings under the support of the intelligent processing system based on sensors and intelligent base, has functions of sensing inference and learning, and it accomplishes control for an intelligent automatic machine, such as an intelligent robot, which realizes high-speed and high-accuracy motions.

## Claims

1. A processor system comprising:
a plurality of processors (1; BPE) with associated local memories (18, 20); and
a common bus switch (8a - 8d) for connecting any one of said processors (1) to a first system bus (14a - 14d);
**characterized** in that
each of said processors (1; BPE) includes:
a) first and second local buses (28, 29);
b) a common bus (12);
c) first CPU means (15; CPU 0) connected to said first local bus (28) for receiving first data from said first local bus (28), performing first processing based on the receiving first data, and selectively generating first information while performing the first processing;
d) second CPU means (16; CPU 1) connected to said second local bus (29) for receiving second data from said second local bus (29), performing second processing based on the first information and the received second data, and selectively generating an access request while performing the second processing;
e) communication means (17) connected to said first and second CPU means (15, 16), and responsive to generation of the first information by said first CPU means (15) for applying the first information to said second CPU means (16);
f) switching means (24) connected to said first and second local buses (28, 29) and said second CPU means (16) for normally connecting said common bus (12) to said first local bus (28) and responsive to generation of an access request by said second CPU means (16) for temporarily connecting said common bus (12) to said second local bus (29) and then re-connecting said common bus to said first local bus (28), whereby frequency of access to said common bus (12) by said first CPU means (15), while said first CPU means (15) is performing the first processing, is greater than the frequency of access to said common bus (12) by said second CPU means (16), while said second CPU means is performing the second processing, and
g) first system bus switch means (8) for controlling connection of said first system bus (14) with the common bus (12) of each of said processors (1; BPE).

2. A processor system according to claim 1, further comprising a common memory (9) connected to said first system bus (14; 14a - 14d) for allowing access to information from each of said processors (1).

3. A processor system according to any one of claims 1 and 2, wherein said plurality of processors (1) are adapted to perform processing in parallel.

4. A processor system according to any one of claims 1 to 3, wherein
said communication means (17) includes means (60, 61, 66, 67, 68) responsive to writing of the first information in a first specific area (63) thereof for generating a first interrupt request (on line 32);
said first CPU means (15) includes means (64) for selectively writing the first information in said first specific area of said communication means (17) while performing the first processing; and
said second CPU means (16) includes means (65) for reading out the first information from said first specific area of said communication means (17) in response to the first interrupt request (32) from said communication means while performing the second processing.

5. A processor system according to any one of claims 1 to 4, wherein
said second CPU means (16) includes means (65) for selectively outputting second information to said communication means (17) while performing the second processing;
said communication means (17) includes means (60, 61, 62, 66) connected to said first and second CPU means (15, 16) for causing said first CPU means to receive the second information from said second CPU means; and
said first CPU means (15) includes means (64) for receiving the second information.

6. A processor system according to claim 5, wherein
said communication means (17) further includes means (60, 62, 66, 67, 69) for generating a second interrupt request (on line 33) in response to writing of the second information in a second specific area thereof;
said second CPU means (16) further includes means (65) for selectively writing the second information in said second specific area of said communication means (17) while performing the second processing; and
said first CPU means (15) further includes means (64) for reading out the second information from said second specific area of said communication means (17) in response to the second interrupt request (33) from said communication means (17) while performing the first processing.

7. A processor system according to any one of claims 1 to 6, further comprising:
a second system bus (100); and
second system bus switch means (102) for controlling connection of said second system with the second CPU means (16) within each of said processors (1; BPE).

8. A processor system according to any one of claims 1 to 7, wherein
said first and second CPU means (15, 16) include memories (18, 20) for receiving and storing programs or data for the first and second processings, respectively.

9. A processor system according to any one of claims 1 to 8, wherein each of said processors (1; BPE) consists of a CPU module, comprising:
a dual port RAM (DPR) means (17) responsive to writing of a first information in a first specific area (63) thereof for generating a first interrupt request (on line 32);
first and second local buses (28, 29);
a first CPU (15) connected to said first local bus (28) and said dual port RAM means (17), for performing a first processing in accordance with a first program and selectively storing first information in said first specific area (63) of said dual port means (17) while performing the first processing;
a first memory (18) connected to said first local bus (28) for storing the first program, the first specific area (63) being included in a first memory map of said first CPU (15);
a second CPU (16) connected to said second local bus (29) and said dual port (RAM means (17), for performing a second processing in accordance with a second program independent of the performance of the first processing by said first CPU (15), and reading out the first information from said first specific area (63) of said dual port RAM (17) in response to a first interrupt request (32) from said dual port RAM while performing the second processing; and
a second memory (20) connected to said second bus (29) for storing the second program, the first specific area being included in a second memory map of said second CPU (16).

10. A processor system according to claim 9, wherein said CPU module further comprises:
a common bus (12);
switching means (24) coupled to said first common bus (28), said second common bus (29) and said common bus (12) and capable of alternatively assuming a first switching condition in which said first common bus (28) is coupled to said common bus (12) for transfer of information therebetween and a second switching condition in which said second common bus (29) is coupled to said common bus (12) for transfer of information therebetween; and
switching control means (22) responsive to signals from said first CPU (15) and said second CPU (16) for controlling the condition of said switching means (24) in accordance with communication requirements of said first CPU, said second CPU, said first memory (18), and said second memory (19).

11. A processor system according to any one of claims 9 and 10, wherein
said dual port RAM (17) includes means (60, 61, 66, 67, 68) responsive to writing of second information in a second specific area thereof for generating a second interrupt request (33);
said second CPU (16) includes means for selectively storing second information in said second specific area of said dual port RAM (17) while performing the second processing; and
said first CPU (15) includes means for reading out the second information from said second specific area of said dual port RAM (17) in response to generation of the second interrupt request (33) by said dual port RAM while performing the first processing.

12. A processor system according to any one of claims 9 to 11, wherein said dual port RAM (17) includes:
a memory element (63) having the first specific area therein for storing the first information from said first CPU (15) for transfer to said second CPU (16) and having the second specific area therein for storing the second information from said second CPU for transfer to said first CPU (15);
first and second buffer means (61, 62) for allowing access to said first specific area of said memory element (63) by said first CPU and said second CPU, respectively; and
signal generating means (67, 68, 69) for monitoring whether one of said first CPU (15) and second CPU (16) has access to its respective said specific area in said memory element (63), and for generating a transfer signal when said one has completed access to said respective specific area, thereby allowing data transfer from said respective specific area to the other of said first CPU and said second CPU.

13. A processor system according to claim 12, wherein said signal generating means (67, 68, 69) includes:
a decoder (67) for monitoring whether the first or second information is transferred to said first or second specific area from said first CPU (15) or said second CPU (16), respectively, and for generating the transfer signal when the transfer of information is completed; and
a pair of flip-flop (68, 69) responsive to the transfer signal for applying the respective first or second interrupt request to said other of said first CPU and said second CPU.

14. A processor system according to claim 13, wherein said decoder (67) includes means for monitoring the transfer of the first or second information from said memory element (63) to said other of said first CPU and said second CPU and for terminating the first or second interrupt signal when such transfer is completed.

15. A processor system according to any one of claims 9 to 14, further comprising:
a first local input/output controller (19) connected to said first local bus (28) for controlling input and output of information to and from said first CPU (15); and
a second local input/output controller (21) connected to said second local bus (29) for controlling input and output of information to and from said second CPU (16).

16. A processor system according to any one of claims 9 to 15, further comprising a system bus buffer (23) for connecting said second CPU (16) to a system bus (14), permitting said second CPU to access a resource on said system bus.

17. A processor system accoding to any one of claims 9 to 16, wherein said switching means (24) includes means for connecting said common bus (12) with one of said first bus (28) and said second bus (29) in a master-slave mode such that said second CPU (16) is a master CPU and said first CPU (15) is a slave CPU.

18. A processor system according to any one of claims 9 to 17, wherein the first CPU (15) performs control processing as the first processing and the second CPU (16) performs intelligent processing as the second processing.

## Patentansprüche

1. Ein Prozessorsystem, mit:
mehreren Prozessoren (1; BPE) mit zugehörigen lokalen Speichern (18, 20); und
einem gemeinsamen Busschalter (8a - 8d) für die Verbindung eines der Prozessoren (1) mit einem ersten Systembus (14a - 14d);
**dadurch gekennzeichnet,** daß
jeder der Prozessoren (1; BPE) enthält:
a) einen ersten und einen zweiten lokalen Bus (28, 29);
b) einen gemeinsamen Bus (12);
c) eine erste CPU-Einrichtung (15; CPU 0), die mit dem ersten lokalen Bus (28) verbunden ist, um vom ersten lokalen Bus (28) erste Daten zu empfangen, auf der Grundlage der empfangenen ersten Daten eine erste Verarbeitung auszuführen und während der Ausführung der ersten Verarbeitung wahlweise eine erste Information zu erzeugen;
d) eine zweite CPU-Einrichtung (16; CPU 1), die mit dem zweiten lokalen Bus (29) verbunden ist, um vom zweiten lokalen Bus (29) zweite Daten zu empfangen, auf der Grundlage der ersten Information und der empfangenen Zweiten Daten eine zweite Verarbeitung auszuführen und während der Ausführung der zweiten Verarbeitung wahlweise eine Zugriffsanforderung zu erzeugen;
e) eine Übermittlungseinrichtung (17), die mit der ersten und mit der zweiten CPU-Einrichtung (15, 16) verbunden ist und aufgrund der Erzeugung der ersten Information durch die erste CPU-Einrichtung (15) diese erste Information in die zweite CPU-Einrichtung (16) eingibt;
f) eine Schalteinrichtung (24), die mit dem ersten und mit dem zweiten lokalen Bus (28, 29) und mit der zweiten CPU-Einrichtung (16) verbunden ist, um normalerweise den gemeinsamen Bus (12) mit dem ersten lokalen Bus (28) zu verbinden und aufgrund der Erzeugung einer Zugriffsanforderung durch die zweite CPU-Einrichtung (16) vorübergehend den gemeinsamen Bus (12) mit dem zweiten lokalen Bus (29) zu verbinden und anschließend den gemeinsamen Bus vom ersten lokalen Bus (28) zu trennen, wobei die Häufigkeit des Zugriffs auf den gemeinsamen Bus (12) durch die erste CPU-Einrichtung (15) dann, wenn diese die erste Verarbeitung ausführt, größer ist als die Häufigkeit des Zugriffs auf den gemeinsamen Bus (12) durch die zweite CPU-Einrichtung (16), wenn diese die zweite Verarbeitung ausführt; und
g) eine erste Systembus-Schalteinrichtung (8) für die Steuerung der Verbindung des ersten Systembusses (14) mit dem gemeinsamen Bus (12) eines jeden der Prozessoren (1; BPE).

2. Ein Prozessorsystem gemäß Anspruch 1, das ferner einen gemeinsamen Speicher (9) aufweist, der mit dem ersten Systembus (14; 14a - 14d) verbunden ist, um einen Zugriff auf die Information von jedem der Prozessoren (1) zu ermöglichen.

3. Ein Prozessorsystem gemäß einem der Ansprüche 1 und 2, bei dem die mehreren Prozessoren (1) so beschaffen sind, daß sie eine Parallelverarbeitung ausführen können.

4. Ein Prozessorsystem gemäß einem der Ansprüche 1 bis 3, bei dem
die Übermittlungseinrichtung (17) Einrichtungen (60, 61, 66, 67, 68) enthält, die aufgrund des Schreibens der ersten Information in einen ersten besonderen Bereich (63) derselben (auf der Leitung 32) eine erste Unterbrechungsanforderung erzeugen;
die erste CPU-Einrichtung (15) eine Einrichtung (64) enthält, um wahlweise die erste Information in den ersten besonderen Bereich der Übermittlungseinrichtung (17) zu schreiben, wenn sie die erste Verarbeitung ausführt; und
die zweite CPU-Einrichtung (16) eine Einrichtung (65) enthält, um aufgrund der ersten Unterbrechungsanforderung (32) von der Übermittlungseinrichtung die erste Information aus dem ersten besonderen Bereich der Übermittlungseinrichtung (17) auszulesen, wenn sie die zweite Verarbeitung ausführt.

5. Ein Prozessorsystem gemäß einem der Ansprüche 1 bis 4, bei dem
die zweite CPU-Einrichtung (16) eine Einrichtung (65) enthält, um an die Übermittlungseinrichtung (17) wahlweise eine zweite Information auszugeben, wenn sie die zweite Verarbeitung ausführt;
die Übermittlungseinrichtung (17) Einrichtungen (60, 61, 62, 66) enthält, die mit der ersten und mit der zweiten CPU-Einrichtung (15, 16) verbunden sind, um die erste CPU-Einrichtung zu veranlassen, die zweite Information von der zweiten CPU-Einrichtung zu empfangen; und
die erste CPU-Einrichtung (15) eine Einrichtung (64) enthält, um die zweite Information zu empfangen.

6. Ein Prozessorsystem gemäß Anspruch 5, bei dem
die Übermittlungseinrichtung (17) ferner Einrichtungen (60, 62, 66, 67, 69) enthält, um aufgrund des Schreibens der zweiten Information in einen zweiten besonderen Bereich derselben (auf der Leitung 33) eine zweite Unterbrechungsanforderung zu erzeugen;
die zweite CPU-Einrichtung (16) ferner eine Einrichtung (65) enthält, um wahlweise die zweite Information in den zweiten besonderen Bereich der Übermittlungseinrichtung (17) zu schreiben, wenn sie die zweite Verarbeitung ausführt; und
die erste CPU-Einrichtung (15) ferner eine Einrichtung (64) enthält, um aufgrund der zweiten Unterbrechungsanforderung (33) von der Übermittlungseinrichtung (17) die zweite Information aus dem zweiten besonderen Bereich der Übermittlungseinrichtung (17) auszulesen, während sie die erste Verarbeitung ausführt.

7. Ein Prozessorsystem gemäß einem der Ansprüche 1 bis 6, das ferner versehen ist mit:
einem zweiten Bussystem (100); und
einer zweiten Systembus-Schalteinrichtung (102) für die Steuerung der Verbindung des zweiten Systems mit der zweiten CPU-Einrichtung (16) in jedem der Prozessoren (1; BPE).

8. Ein Prozessorsystem gemäß einem der Ansprüche 1 bis 7, bei dem
die erste und die zweite CPU-Einrichtung (15, 16) Speicher (18, 20) enthalten, um für die erste bzw. für die zweite Verarbeitung Programme oder Daten zu empfangen und zu speichern.

9. Ein Prozessorsystem gemäß einem der Ansprüche 1 bis 8, bei dem jeder der Prozessoren (1; BPE) aus einem CPU-Modul besteht, welcher umfaßt:
eine Dual-Port-RAM(DPR)-Einrichtung (17), die aufgrund des Schreibens einer ersten Information in einen ersten besonderen Bereich (63) derselben (auf der Leitung 32) eine erste Unterbrechungsanforderung erzeugt;
einen ersten und einen zweiten lokalen Bus (28, 29);
eine erste CPU (15), die mit dem ersten lokalen Bus (28) und mit der Dual-Port-RAM-Einrichtung (17) verbunden ist, um eine erste Verarbeitung gemäß einem ersten Programm auszuführen und um während der Ausführung dieser ersten Verarbeitung wahlweise die erste Information in dem ersten besonderen Bereich (63) der Dual-Fort-Einrichtung (17) zu speichern;
einen ersten Speicher (18), der mit dem ersten lokalen Bus (28) verbunden ist, um das erste Programm zu speichern, wobei der erste besondere Bereich (63) in einer ersten Adressenumwandlungstabelle der ersten CPU (15) enthalten ist;
eine zweite CPU (16), die mit dem zweiten lokalen Bus (29) und mit der Dual-Port-RAM-Einrichtung (17) verbunden ist, um eine zweite Verarbeitung gemäß einem zweiten Programm auszuführen, welches unabhängig von der Leistung der ersten Verarbeitung durch die erste CPU (15) ist, und um während der Ausführung der zweiten Verarbeitung aufgrund einer ersten Unterbrechungsforderung (32) vom Dual-Port-RAM die erste Information vom ersten besonderen Bereich (63) des Dual-Port-RAM (17) auszulesen; und
einen zweiten Speicher (20), der mit dem zweiten Bus (29) verbunden ist, um das zweite Programm zu speichern, wobei der erste besondere Bereich in einer zweiten Adressenumwandlungstabelle der zweiten CPU (16) enthalten ist.

10. Ein Prozessorsystem gemäß Anspruch 9, bei dem der CPU-Modul ferner umfaßt:
einen gemeinsamen Bus (12);
eine Schalteinrichtung (24), die mit dem ersten gemeinsamen Bus (28), dem zweiten gemeinsamen Bus (29) und dem gemeinsamen Bus (12) verbunden ist und abwechselnd einen ersten Schaltzustand, in dem der erste gemeinsame Bus (28) mit dem gemeinsamen Bus (12) verbunden ist, um zwischen ihnen Information zu übertragen, und einen zweiten Schaltzustand annehmen kann, in dem der zweite gemeinsame Bus (29) mit dem gemeinsamen Bus (12) verbunden ist, um zwischen ihnen Information zu übertragen; und
eine Schaltsteuereinrichtung (22), die aufgrund von Signalen von der ersten CPU (15) und von der zweiten CPU (16) den Zustand der Schalteinrichtung (24) entsprechend den Übermittlungsanforderungen von der ersten CPU, der zweiten CPU, dem ersten Speicher (18) und dem zweiten Speicher (19) steuert.

11. Ein Prozessorsystem gemäß einem der Ansprüche 9 und 10, bei dem
das Dual-Port-RAM (17) Einrichtungen (60, 61, 66, 67, 68) enthält, die aufgrund des Schreibens der zweiten Information in einen zweiten besonderen Bereich desselben eine zweite Unterbrechungsanforderung (33) erzeugt;
die zweite CPU (16) eine Einrichtung enthält, um wahlweise die zweite Information in dem zweiten besonderen Bereich des Dual-Port-RAM (17) zu speichern, wenn sie die zweite Verarbeitung ausführt; und
die erste CPU (15) eine Einrichtung enthält, um aufgrund der Erzeugung der zweiten Unterbrechungsanforderung (33) durch das Dual-Port-RAM die zweite Information aus dem zweiten besonderen Bereich des Dual-Port-RAM (17) auszulesen, wenn sie die erste Verarbeitung ausführt.

12. Ein Prozessorsystem gemäß einem der Ansprüche 9 bis 11, bei dem das Dual-Port-RAM (17) enthält:
ein Speicherelement (63), das den ersten besonderen Bereich enthält, in dem die erste Information von der ersten CPU (15) für die Übertragung an die zweite CPU (16) gespeichert ist, und das den zweiten besonderen Bereich enthält, in dem die zweite Information von der zweiten CPU für die Übertragung an die erste CPU (15) gespeichert ist;
eine erste und eine zweite Puffereinrichtung (61, 62), um einen Zugriff auf den ersten besonderen Bereich des Speicherelements (63) durch die erste CPU bzw. durch die zweite CPU zu erlauben; und
Signalerzeugungseinrichtungen (67, 68, 69), die überwachen, ob die erste CPU (15) oder die zweite CPU (16) auf ihren jeweiligen besonderen Bereich im Speicherelement (63) zugreift, und die ein Übertragungssignal erzeugen, wenn diese eine den Zugriff auf ihren jeweiligen besonderen Bereich beendet hat, wodurch eine Datenübertragung vom jeweiligen besonderen Bereich an die jeweils andere der ersten CPU und der zweiten CPU möglich ist.

13. Ein Prozessorsystem gemäß Anspruch 12, bei dem die Signalerzeugungseinrichtungen (67, 68, 69) enthalten:
einen Dekodierer (67), der überwacht, ob die erste oder die zweite Information von der ersten CPU (15) bzw. von der zweiten CPU (16) an den ersten bzw. an den zweiten besonderen Bereich übertragen wird, und der das Übertragungssignal erzeugt, wenn die Informationsübertragung beendet ist; und
ein Paar von Flip-Flops (68, 69), die aufgrund des Übertragungssignals die erste bzw. die zweite Unterbrechungsanforderung in die jeweils andere der ersten CPU und der zweiten CPU eingeben.

14. Ein Prozessorsystem gemäß Anspruch 13, bei dem der Dekodierer (67) eine Einrichtung aufweist, die die Übertragung der ersten oder der zweiten Information vom Speicherelement (63) an die andere der ersten CPU und der zweiten CPU überwacht und die die das erste oder das zweite Unterbrechungssignal beendet, wenn eine solche Übertragung beendet ist.

15. Ein Prozessorsystem gemäß einem der Ansprüche 9 bis 14, das ferner versehen ist mit:
einer ersten lokalen Eingangs-/Ausgangs-Steuereinrichtung (19), die mit dem ersten lokalen Bus (28) verbunden ist, um den Eingang und den Ausgang von Information in die erste CPU (15) bzw. aus der ersten CPU zu steuern; und
einer zweiten lokalen Eingangs-/Ausgangs-Steuereinrichtung (21), die mit dem zweiten lokalen Bus (29) verbunden ist, um den Eingang und den Ausgang der Information in die zweite CPU (16) bzw. aus der zweiten CPU zu steuern.

16. Ein Prozessorsystem gemäß einem der Ansprüche 9 bis 15, ferner mit einem Systembus-Puffer (23) für die Verbindung der zweiten CPU (16) mit einem Systembus (14), um der zweiten CPU einen Zugriff auf ein Betriebsmittel im Systembus zu ermöglichen.

17. Ein Prozessorsystem gemäß einem der Ansprüche 9 bis 16, bei dem die Schalteinrichtung (24) eine Einrichtung für die Verbindung des gemeinsamen Busses (12) mit dem ersten Bus (28) oder mit dem zweiten Bus (29) in einer Master-Slave-Betriebsart enthält, derart, daß die zweite CPU (16) eine Master-CPU ist und die erste CPU (15) eine Slave-CPU ist.

18. Ein Prozessorsystem gemäß einem der Ansprüche 9 bis 17, bei dem die erste CPU (15) als erste Verarbeitung eine Steuerverarbeitung ausführt und die zweite CPU (16) als zweite Verarbeitung eine frei programmierbare Verarbeitung ausführt.

## Revendications

1. Système à processeurs comprenant :
une pluralité de processeurs (1;BPE) auxquels sont associées des mémoires locales (18,20); et
un interrupteur de bus commun (8a-8d) servant à raccorder l'un quelconque desdits processeurs (1) à un premier bus (14a-14d) de système;
caractérisé en ce que
chacun desdits processeurs (1;BPE) comprend :
a) des premier et second bus locaux (28,29);
b) un bus commun (12);
c) des premiers moyens formant unité centrale (15; CPU 0) raccordés audit premier bus local (28) pour recevoir des premières données en provenance dudit premier bus local (28), exécuter un premier traitement sur la base des premières données reçues, et produire de façon sélective une première information pendant l'exécution du premier traitement;
d) des seconds moyens formant unité centrale (16; CPU 1) raccordés audit second bus local (29) pour recevoir des secondes données à partir dudit second bus local (29), exécuter un second traitement sur la base de la première information et des secondes données reçues, et produire de façon sélective une demande d'accès au cours de l'exécution du second traitement;
e) des moyens de communication (17) raccordés auxdits premiers et seconds moyens formant unité centrale (15,16) et répondant à la production de la première information par lesdits premiers moyens formant unité centrale (15) pour appliquer cette première information auxdits seconds moyens formant unité centrale (16);
f) des moyens de commutation (24) raccordés auxdits premier et second bus locaux (28,29) et auxdits seconds moyens formant unité centrale (16) pour raccorder normalement ledit bus commun (12) audit premier bus local (28) et répondant à la production d'une demande d'accès produite par lesdits seconds moyens formant unité centrale (16) pour raccorder temporairement ledit bus commun (12) audit second bus local (29), puis reconnecter ledit bus commun audit premier bus local (28), la fréquence d'accès desdits premiers moyens formant unité centrale (15) audit bus commun (12), alors que lesdits premiers moyens formant unité centrale (15) exécutent le premier traitement, étant supérieure à la fréquence d'accès desdits seconds moyens formant unité centrale (16) audit bus commun (12) alors que lesdits seconds moyens formant unité centrale exécutent le second traitement, et
g) des moyens de commutation (8) du premier bus de système pour commander le raccordement dudit premier bus (14) de système au bus commun (12) de chacun desdits processeurs (1;BPE).

2. Système à processeurs selon la revendication 1, comprenant en outre une mémoire commune (9) raccordée audit premier bus (14;14a;14d) de système pour permettre l'accès d'une information provenant de chacun desdits processeurs (1).

3. Système à processeurs selon l'une quelconque des revendications 1 et 2, dans lequel ladite pluralité de processeurs (1) sont adaptés pour exécuter un traitement en parallèle.

4. Système à processeurs selon l'une quelconque des revendications 1 à 3, dans lequel
lesdits moyens de communication (17) comprennent des moyens (60,61,66,67,68) répondant à l'enregistrement de la première information dans une première zone spécifique (63) de ces moyens pour produire une première demande d'interruption (dans la ligne 32);
lesdits premiers moyens formant unité centrale (15) comprennent des moyens (64) pour enregistrer de façon sélective la première information dans ladite première zone spécifique desdits moyens de communication (17) lors de l'exécution du premier traitement; et
lesdits seconds moyens formant unité centrale (16) comprennent des moyens (65) pour lire la première information à partir de ladite première zone spécifique desdits moyens de communication (17) en réponse à la première demande d'interruption (32) provenant desdits moyens de communication, lors de l'exécution du second traitement.

5. Système à processeurs selon l'une quelconque des revendications 1 à 4, dans lequel
lesdits seconds moyens formant unité centrale (16) comprennent des moyens (65) pour délivrer de façon sélective une seconde information auxdits moyens de communication (17) lors de l'exécution du second traitement;
lesdits moyens de communication (17) comprennent des moyens (60,61,62,66) raccordés auxdits premiers et seconds moyens formant unité centrale (15,16) pour amener lesdits premiers moyens formant unité centrale à recevoir la seconde information à partir desdits seconds moyens formant unité centrale; et
lesdits premiers moyens formant unité centrale (15) comprennent des moyens (64) pour recevoir la seconde information.

6. Système à processeurs selon la revendication 5, dans lequel
lesdits moyens de communication (17) comprennent en outre des moyens (60,62,66,67,69) pour produire une seconde demande d'interruption (dans la ligne 33) en réponse à l'enregistrement de la seconde information dans une seconde zone spécifique de ces moyens;
lesdits seconds moyens formant unité centrale (16) comprennent en outre des moyens (65) pour enregistrer de façon sélective la seconde information dans ladite seconde zone spécifique desdits moyens de communication (17) lors de l'exécution du second traitement; et
lesdits premiers moyens formant unité centrale (15) comprennent en outre des moyens (64) pour lire la seconde information à partir de ladite seconde zone spécifique desdits moyens de communication (17) en réponse à la seconde demande d'interruption (33) provenant desdits moyens de communication (17), lors de l'exécution du premier traitement.

7. Système à processeurs selon l'une quelconque des revendications 1 à 6, comprenant en outre :
un second bus (100) de système; et
des moyens de commutation (102) du second bus de système pour commander le raccordement dudit second bus de système aux seconds moyens formant unité centrale (16) à l'intérieur de chacun desdits processeurs (1;BPE).

8. Système à processeurs selon l'une quelconque des revendications 1 à 7, dans lequel
lesdits premiers et seconds moyens formant unité centrale (15,16) comprennent des mémoires (18,20) pour recevoir et mémoriser des programmes ou des données respectivement pour les premier et second traitements.

9. Système à processeurs selon l'une quelconque des revendications 1 à 8, dans lequel chacun desdits processeurs (1;BPE) est constitué par un module formant unité centrale, comprenant :
des moyens (17) de mémoire RAM à deux ports (DPR). répondant à l'enregistrement d'une première information dans une première zone spécifique (63) de ces moyens pour la production d'une première demande d'interruption (dans la ligne 32);
des premier et second bus locaux (28,29);
une première unité centrale (15) raccordée audit premier bus local (28) et auxdits moyens (17) de mémoire RAM à deux ports, pour l'exécution d'un premier traitement en fonction d'un premier programme et la mémorisation sélective d'une première information dans ladite première zone spécifique (63) desdits moyens (17) à deux ports, au cours de l'exécution du premier traitement;
une première mémoire (18) raccordée audit premier bus local (28) pour mémoriser le premier programme, la première zone spécifique (63) étant incluse dans une première carte de mémoire de ladite première unité CPU (15);
une seconde unité centrale (16) raccordée audit second bus local (29) et auxdits moyens (17) de mémoire RAM à deux ports, pour l'exécution d'un second traitement en fonction d'un second programme indépendant de l'exécution du premier traitement par ladite première unité centrale (15), et la lecture de la première information à partir de ladite première zone spécifique (63) de ladite mémoire RAM (17) à deux ports, en réponse à une première demande d'interruption (32) provenant de ladite mémoire RAM à deux ports lors de l'exécution du second traitement; et une seconde mémoire (20) raccordée audit second bus (29) pour mémoriser le second programme, la première zone spécifique étant incluse dans une seconde carte de mémoire de ladite seconde unité centrale (16).

10. Système à processeurs selon la revendication 9, dans lequel ledit module formant unité centrale comporte en outre :
un bus commun (12);
des moyens de commutation (24) couplés audit premier bus commun (28), audit second bus commun (29) et audit bus commun (12) et aptes à prendre alternativement un premier état de commutation, dans lequel ledit premier bus commun (28) est couplé audit bus commun (12) pour le transfert d'une information entre ces bus, et un second état de commutation, dans lequel ledit second bus commun (29) est couplé audit bus commun (12) pour le transfert d'une information entre ces bus; et
des moyens de commande de commutation (22) répondant à des signaux provenant de ladite première unité centrale (15) et de ladite seconde unité centrale (16) pour commander l'état desdits moyens de commutation (24) en fonction d'exigences de communication de ladite première unité centrale, de ladite seconde unité centrale de ladite première mémoire (18) et de ladite seconde mémoire (19).

11. Système à processeurs selon l'une quelconque des revendications 9 et 10, dans lequel :
ladite mémoire RAM à deux ports (17) comprend des moyens (60,61,66,67,68) répondant à l'enregistrement d'une seconde information dans une seconde zone spécifique de ces moyens pour la production d'une seconde demande d'interruption (33);
ladite seconde unité centrale (16) comprend des moyens pour mémoriser de façon sélective une seconde information dans ladite seconde zone spécifique de ladite mémoire RAM à deux ports (17), lors de l'exécution du second traitement; et
ladite première unité centrale (15) comprend des moyens pour lire la seconde information à partir de ladite seconde zone spécifique de ladite mémoire à deux ports RAM (17) en réponse à la production de la seconde demande d'interruption (33) par ladite mémoire RAM à deux ports, lors de l'exécution du premier traitement.

12. Système à processeurs selon l'une quelconque des revendications 9 à 11, dans lequel ladite mémoire RAM à deux ports (17) comprend :
un élément de mémoire (63) contenant la première zone spécifique pour mémoriser la première information provenant de ladite première unité centrale (15) pour son transfert à ladite seconde unité centrale (16) et contenant la seconde zone spécifique pour la mémorisation de la seconde information provenant de ladite seconde unité centrale pour son transfert à ladite première unité centrale (15);
des premier et second moyens formant tampons (61,62) pour permettre l'accès à ladite première zone spécifique dudit élément de mémoire (63) respectivement par ladite première unité centrale et par ladite seconde unité centrale; et
des moyens de production de signal (67,68,69) pour vérifier si ladite première unité centrale (15) ou ladite seconde unité centrale (16) a accès à ladite zone spécifique, qui lui est propre, dans ledit élément de mémoire (63), et produire un signal de transfert lorsque ladite unité centrale a terminé son accès à ladite zone spécifique respective, ce qui permet un transfert des données depuis ladite zone spécifique respective en direction de l'autre desdites première et seconde unités centrales.

13. Système à processeurs selon la revendication 12, dans lequel lesdits moyens de production de signal (67,68,69) comprennent :
un décodeur (67) pour vérifier si la première ou la seconde information est transférée à ladite première ou seconde zone spécifique respectivement à partir de ladite première unité centrale (15) ou à partir de ladite seconde unité centrale (16), et produire le signal de transfert lorsque le transfert de l'information est achevé; et
un couple de bascules bistables (68,69) répondant au signal de transfert pour appliquer la première ou seconde demande respective d'interruption à l'autre desdites première et seconde unités centrales.

14. Système à processeurs selon la revendication 13, dans lequel ledit décodeur (67) comprend des moyens pour contrôler le transfert de la première ou de la seconde information depuis ledit élément de mémoire (63) en direction de l'autre desdites première et seconde unités centrales et pour interrompre le premier ou le second signal d'interruption lorsqu'un tel transfert est achevé.

15. Système à processeurs selon l'une quelconque des revendications 9 à 14, comprenant en outre :
un premier dispositif local de commande d'entrée/sortie (19) raccordé audit premier bus local (28) pour commander l'entrée et la sortie d'une information dans et à partir de ladite première unité centrale (15); et
un second dispositif local de commande d'entrée/sortie (21) raccordé audit second bus local (29) pour commander l'entrée et la sortie d'une information dans et en provenance de ladite seconde unité centrale (16).

16. Système à processeurs selon l'une quelconque des revendications 9 à 15, comportant en outre un tampon (23) de bus de système pour le raccordement de ladite seconde unité centrale (16) à un bus (14) de système, de manière à permettre l'accès de ladite seconde unité centrale à une ressource située dans ledit bus de système.

17. Système à processeurs selon l'une quelconque des revendications 9 à 16, dans lequel lesdits moyens de commutation (24) comprennent des moyens pour raccorder ledit bus commun (12) à l'un desdits premier et second bus (28,29) dans un mode maître-esclave de sorte que ladite seconde unité centrale (16) est une unité centrale maître et que ladite première unité centrale (15) est une unité centrale esclave.

18. Système à processeurs selon l'une quelconque des revendications 9 à 17, dans lequel la première unité centrale (15) exécute un traitement de commande en tant que premier traitement, et la seconde unité centrale (16) exécute un traitement intelligent en tant que second traitement.
